(19) Europäisches Patentamt
European Patent Office
Office européen des brevets

(11) **EP 3 485 507 B1**

(12) **EUROPEAN PATENT SPECIFICATION**

(45) Date of publication and mention
of the grant of the patent:
**03.03.2021 Bulletin 2021/09**

(51) Int Cl.:
*H01L 39/22* (2006.01)      *H01L 39/24* (2006.01)

(21) Application number: **17769552.5**

(22) Date of filing: **23.03.2017**

(86) International application number:
**PCT/IB2017/051676**

(87) International publication number:
**WO 2017/163205 (28.09.2017 Gazette 2017/39)**

(54) **FEMTOSECOND LASER BASED METHOD FOR FABRICATION OF MICRO- AND NANO-CONSTRICTION TYPE STRUCTURES ON A YBA2-CU3O7-X SUPERCONDUCTING THIN FILM**

AUF FEMTOSEKUNDENLASER BASIERENDES VERFAHREN ZUR HERSTELLUNG VON MIKRO- UND NANOKONSTRIKTIONSARTIGEN STRUKTUREN AUF EINER YBA2-CU3O7-X-SUPERLEITENDEN DÜNNSCHICHT

PROCÉDÉ À BASE DE LASER FEMTOSECONDE POUR LA FABRICATION DE STRUCTURES DE TYPE MICRO ET NANO-CONSTRICTION SUR UN FILM MINCE SUPRACONDUCTEUR YBA2-CU3O7-X

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **23.03.2016 ZA 201601975**

(43) Date of publication of application:
**22.05.2019 Bulletin 2019/21**

(73) Proprietor: **Unisa**
**0002 Pretoria (ZA)**

(72) Inventors:
• **VALLABHAPURAPU, Vijaya Srinivasu**
**0002 Pretoria (ZA)**
• **UMENNE, Patrice**
**0002 Pretoria (ZA)**

(74) Representative: **Dummett Copp LLP**
**25 The Square**
**Martlesham Heath**
**Ipswich IP5 3SL (GB)**

(56) References cited:
JP-A- 2008 053 373    US-A- 5 143 894
US-A- 5 356 870       US-A- 5 483 037
US-A1- 2005 226 287   US-A1- 2013 119 027

US-A1- 2013 216 779    US-A1- 2014 161 998

• MURAKAMI H ET AL: "Ultrafast optical magnetic flux generation and the improved THz-imaging", PHYSICA C, NORTH-HOLLAND PUBLISHING, AMSTERDAM, NL, vol. 392-396, 1 October 2003 (2003-10-01), pages 401-405, XP004455227, ISSN: 0921-4534, DOI: 10.1016/S0921-4534(03)00786-X
• MURAKAMI H ET AL: "Optical response of BSCCO thin film in superconducting state", PHYSICA C, NORTH-HOLLAND PUBLISHING, AMSTERDAM, NL, vol. 367, no. 1-4, 15 February 2002 (2002-02-15), pages 317-321, XP027361747, ISSN: 0921-4534 [retrieved on 2002-02-15]
• MUTO H ET AL: "New PLAD apparatus and fabrication of epitaxial films and junctions of functional materials: SiC, GaN, ZnO, diamond and GMR layers", APPLIED SURFACE SCIENCE, ELSEVIER, AMSTERDAM, NL, vol. 252, no. 13, 30 April 2006 (2006-04-30), pages 4886-4896, XP024893368, ISSN: 0169-4332, DOI: 10.1016/J.APSUSC.2005.07.113 [retrieved on 2006-04-30]

- BUETTNER U ET AL: "Fabrication of submicron YBCO Josephson junctions by a sample mosaic navigation assisted laser etching process", SUPERCONDUCTOR SCIENCE AND TECHNOLOGY, IOP PUBLISHING, TECHNO HOUSE, BRISTOL, GB, vol. 20, no. 11, 1 November 2007 (2007-11-01), pages S426-S429, XP020128523, ISSN: 0953-2048

- S Proyer ET AL: "Patterning of YBCO Films by Excimer-Laser Ablation", Applied Physics A, vol. 58, no. 5, 1 May 1994 (1994-05-01), pages 471-474, XP055722181, DOI: 10.1007/BF00332439

## Description

### FIELD OF THE INVENTION

This invention relates to a Femtosecond Laser based method for fabrication of micro- and nano-constriction type structures on a $YBa_2Cu_3O_{7-x}$ Superconducting thin film and to a new superconductor device.

### BACKGROUND OF THE INVENTION

Constriction type Josephson junctions, Superconducting Quantum Interference Devices (SQUIDS) and Microstripline resonators are important superconducting devices that have unique properties and advantages for applications in the fields of sensors & detectors, advanced electronics, imaging, in communication industries and quantum computers. With the discovery of the $YBa_2Cu_3O_{7-x}$ (YBCO) superconductor and of very high quality thin films of the same, now superconducting devices based on YBCO which operate at liquid nitrogen temperature are possible. For this reason, there is an increased activity in the fabrication of Josephson junctions, SQUIDS and the like. Furthermore, patents in this area, such as EP 0 384 521 and US4985117A, reflect the commercial importance of these devices. It is an object of the invention to provide micro - and nano planar structures on YBCO superconducting thin films, that give (a) constriction type Josephson junctions, (b) SQUIDS, and (c) microstripline resonators.

A method of generating multiple optical magnetic flux dots in a YBCO strip line by single shot optical pulse irradiations is disclosed in Murakami et al. "Ultrafast optical magnetic flux generation and the improved THz-imaging", Physica C, vol. 392-396, 2003, pages 401-405. An investigation into the electromagnetic wave radiation property from BSCCO thin film grown by a laser ablation method is disclosed in Murakami et al. "Optical response of BSCCO thin film in superconducting state", Physica C, vol. 367, 2002, pages 317-321.

A pulsed laser ablation-deposition (PLAD) apparatus and techniques for fabricating films of high temperature or functional materials is disclosed in Muto et al. "New PLAD apparatus and fabrication of epitaxial films and junctions of functional materials: SiC, GaN, ZnO, diamond and GMR layers", Applied Surface Science, vol. 252, 2006, pages 4886-4896. A structural ablation of YBCO layers by fs laser pulses is in particular revealed in the prior documents 1) BUETTNER U ET AL: "Fabrication of submicron YBCO Josephson junctions by a sample mosaic navigation assisted laser etching process",SUPERCONDUCTOR SCIENCE AND TECHNOLOGY, IOP PUBLISHING, TECHNO HOUSE, BRISTOL, GB, vol. 20, no. 11, 1 November 2007 (2007-11 -01), pages S426-S429 and 2) S. Proyer ET AL: "Patterning of YBCO Films by Excimer-Laser Ablation",Applied Physics A, vol. 58, no. 5, 1 May 1994 (1994-05-01), pages 471-474.

JP 2008 053373 A discloses an optical input element capable of achieving an optical interface and comprising a control current wire constructed by a high temperature superconductor, a bias current wire consisting of a high temperature superconductor and including a Josephson junction.

### SUMMARY OF THE INVENTION

According to one aspect of the invention, there is provided a method of manufacturing micro- and nano-constriction type structures on a YBCO thin film for a superconductor device, the method including ablating a predefined pattern onto the thin film by means of a femtosecond laser, characterized in that the predefined pattern defines an S-shaped constriction defined by two opposed parallel lines, ends of which overlap at least partially to define a constriction between them.

In this specification, the definition of micro-constriction type structures relates to structures of which the constriction size is in microns and submicrons.

In this specification, the definition of nano-constriction type structures relates to structures of which the constriction size is in the nanometer scale.

The term ablating is used to include both processes of ablation and etching, as the effect of the laser on the thin film includes both processes. It is thus to be appreciated that the term ablating is intended to also include etching and lithography.

The thin film may be a $YBa_2Cu_3O_{7-x}$ thin film. The thin film may previously be deposited on any one of: a Magnesium Oxide (MgO) substrate or a Lanthanum Aluminate (LAO) substrate.

The femtosecond laser parameters may be in the following ranges:

the power of the laser to a value of between 1mW and 1W;
the repitition rate of the laser to a value of between 1kHz and 2kHz;
the laser beam feed rate to a value of between $16.6\,\mu m/s$ and $500\,\mu m/s$;
the pulse duration to a value of 130fs;
and the laser beam spot size to a value of between $7.3\,\mu m$ and $17\,\mu m$.

The method may include controlling the laser beam separation distance between laser ablation spots in the range of $8\mu$m to $18\mu$m.

The laser may have a wavelength of about 795nm, a pulse duration of about 130fs and a repetition rate of between 1kHz and 2kHz.

The constriction is preferably of a specific length and width. The spacing between the lines may be in the range of $5\mu$m to $10\mu$m along the width of the thin film.

The predefined pattern to be ablated may be defined by controlling the movement of a translation stage with respect to the laser.

The translation stage may be controlled by a computer aided manufacturing language.

The computer aided manufacturing language may be G code.

The invention extends to a superconductor device which includes a YBCO thin film with a predefined pattern. The predefined pattern defines an S-shaped constriction defined by two opposed parallel lines, ends of which overlap at least partially to define a constriction between them. The thin film of the superconductor device may be $YBa_2Cu_3O_{7-x}$ thin film. The thin film may be previously deposited on any one of a Magnesium Oxide (MgO) or Lanthanum Aluminate (LAO) substrate.

The constrictions preferably range from micron to nano size. The spacing between the lines on the superconductor device may be in the range of $5\mu$m to $10\mu$m along the width of the thin film.

The invention will now be described by way of a non-limiting example only, with reference to the following figures.

**FIGURES**

In the figures:

Figure 1 shows a block diagram of a femtosecond laser experimental set up for fabrication of YBCO constrictions of micron and nano scale in accordance with the invention;

Figure 2 shows a design of a S-shaped constriction according to one aspect of the invention;

Figure 3 shows a conventional constriction design;

Figure 4 shows a profile distribution of an Atomic Force Microscope (AFM) image scan of a laser ablation tunnel and a three-dimensional image of the AFM scan created during the fabrication of a constriction;

Figure 5 shows a plot of the squared ablation diameter ($D^2$) versus the peak laser fluence ($F_0$) for YBCO on a LaO substrate;

Figure 6 shows a profile distribution of an AFM image scan of a laser ablation spot crater created during the fabrication of a constriction at an incident power of 4.22mW and crater depth of 146.2nm, focusing on crater depth.

Figure 7 shows the plot of the ablation crater's depth ($d_{max}$) versus the incident peak fluence ($F_0$) for YBCO;

Figure 8 shows a profile distribution of an AFM image scan of an S-shaped constriction with a power setting of 4.9mW, using a spherical convex lens of 45mm, a constriction width of $1.465\mu$m, a scan area of $75\mu$m and a laser spot separation of $18.7\mu$m;

Figure 9 shows a top view and a three-dimensional view of the constriction of Figure 8, focusing on the width of the constriction.

Figure 10 shows a top view of the constriction in Figure 8; focusing on the length of the constriction.

Figure 11 shows a profile distribution of an AFM image scan of an S-shaped constriction with a power setting 2.104mW, a numerical aperture (NA) 0.25 lens, a constriction width of $1.094\mu$m, a scan area of $40\mu$m and laser spot separation of $8\mu$m;

Figure 12 shows a top view and a three-dimensional view of the constriction of Figure 11, focusing on the width of the constriction.

Figure 13 shows a top view of the constriction of Figure 11, focusing on the length of the constriction.

Figure 14 shows a profile distribution of an AFM image scan of an S-shaped constriction with a power setting of 2.035mW, a spherical convex lens of 30mm, a junction width of 858.3nm, a scan area of $14.6\mu$mX$14.6\mu$m and a laser separation $16.50\mu$m;

Figure 15 shows a top view and a three-dimensional view of the constriction of Figure 14, focusing on the width of the constriction.

Figure 16 shows a three-dimensional view of the AFM image scan Figure 14, focusing on the length of the constriction.

Figure 17 shows a profile distribution of an AFM image scan of an S-shaped constriction with a power setting of 2.035mW, a spherical convex lens of 30mm, a junction width of 576.7nm, a scan area of $49.2\mu$mX$49.2\mu$m and a laser spot separation of $16.00\mu$m; and

Figure 18 shows a top view and a three-dimensional view of the constriction of Figure 17, focusing on the width thereof.

In the figures, like reference numerals denote like parts of the invention, unless otherwise indicated.

## EMBODIMENT OF THE INVENTION

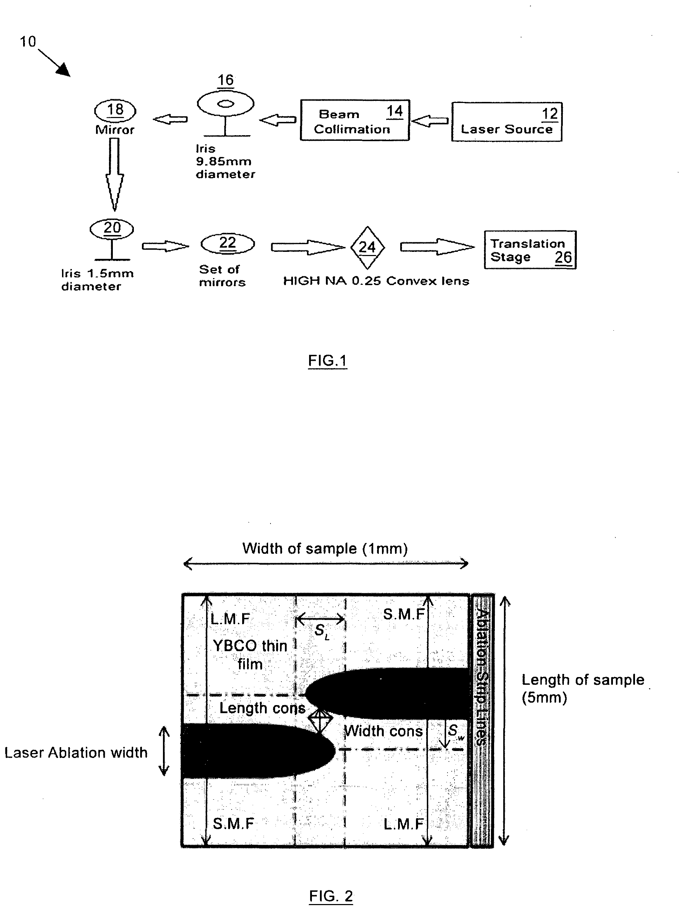

An experimental setup and an example of how the method can be implemented are described in Figure 1 and in the rest of the specification.

The experimental setup briefly consists of a laser source (lamp) (12), of which the radiation parameters are controlled. In this arrangement, the power is controlled around 2.7mW with the laser operating at a wavelength of about 795nm, a pulse duration of 130fs and a pulse repetition rate of 1-2kHz.

The femtosecond laser source (12) has an interface that can be used to control the average laser power output with settings that range from about 1mW to 1000mW, the lamp current and the pulse repetition rate can also be varied.

Lenses (14) are used to collimate the beam. The lenses (14) consist of two cylindrical lenses of physical dimensions of 25mm X 25mm, which are of 50mm and 100mm focal length respectively. The lenses (14) are used to spread out the X-direction of the Gaussian laser beam spot before collimating the beam, because the laser spot is elliptical with the X-direction slightly smaller or narrower than the Y-direction. The laser beam waist is approximately 9.85mm wide on the Y-direction. The collimation lenses are placed perpendicularly to the direction that is to be spread out, in this case, the X-direction.

An iris (16), that has an aperture which is set to 9.85mm, is used to block out certain unwanted parts of the laser spot after collimation on the outer periphery of the Gaussian beam shape. The beam spot diameter coming out of the iris is therefore close to 10mm.

The beam is reflected by a mirror (18) and passes through a 1.5mm diameter iris (20) to filter some of the spherical aberrations and reduce the size of the laser beam spot as far as possible. The second iris (20) is utilized because the cylindrical lenses used to collimate the beam are not perfect and the laser beam spot of 10mm is comparable in size to the cylindrical lenses, such that the beam spot is very close to the edges of the cylindrical lenses, leading to spherical aberrations of the beam. This results in the formation of a bigger ablation spot after focusing with the spherical convex lens or a numerical aperture (NA) objective lens. The iris (20) is set to a manual aperture of 1.5mm. This iris (20) only allows the central core of the laser to pass through with the highest intensity.

The laser beam is passed by another set of mirrors (22) to a NA objective lens (24) of 0.25, with X10 magnification. The NA objective lens (24) is used to focus the laser beam to as small a spot as possible. This enables a laser beam of lower power, approximately 2.0mW coming out of the laser source (12), to be used in etching the YBCO thin film. This result is achieved as the NA objective lens (24) concentrates the power to a smaller spot, thereby increasing the energy density and still ablating the YBCO thin film at low power. However, in another embodiment, the NA objective lens can be replaced with a conventional spherical convex lens having a relative focal length of between 30mm and 45mm.

A translation stage (26) moves in three dimensions, that is (x, y, z), and is used to hold the YBCO sample whilst etching the constriction. The translation stage (26) is controlled by a software program from the manufacturer of the stage. The translation stage can also be programmed using G-code programming language compiled in the software.

Lithography design of a S-shaped constriction

A S-shaped constriction is shaped like the letter "S". A simple G-code program was written for driving the translation stage (26), thereby providing the fabrication of the S-shaped constriction. In the design of the S-shaped constriction, it is possible to control the width and length of the constriction as can be seen in Figure 2. In Figure 2, "S.M.F" refers to a short movement factor, "L.M.F" refers to a long movement factor, and "L.F" refers to a length factor. The ablation strip lines are visible, as well as the length and the width of the constriction.

In the S-shape constriction, one laser ablation spot overlaps the other. Hence, by bringing the laser ablation spots closer along the length of the geometric square sample, it is possible to easily regulate the width of the bridge. Furthermore, by separating the laser spots along the width of the square sample, it is possible to regulate the overlapping length of the bridge as seen in Figure 2.

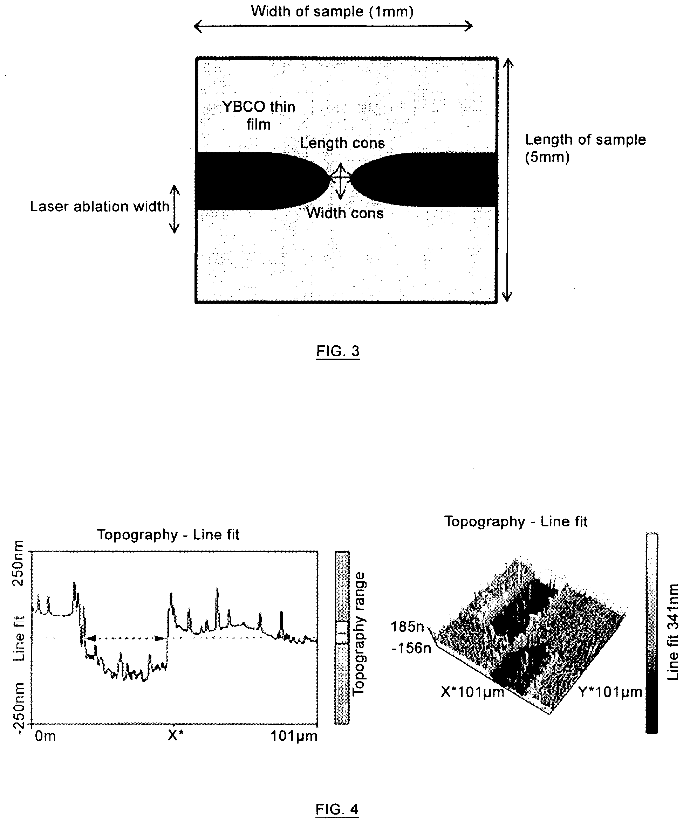

As can be seen in Figure 3, which indicates a standard constriction shape type, the width of the constriction can be controlled only by bringing the ablation spots closer to one another. However, the length of the constriction is restricted to the laser ablation spot size in the standard constriction shape type.

The G-code programming language of the translation stage (26) consists basically of (i) a section of code to etch out the ablation strip lines, and (ii) a section of code to fabricate the S-shaped constriction. The ablation strip lines are used to separate one constriction from another electrically by removing conductive material between the constrictions. They are formed by moving the laser vertically up and down 5mm along the length of the YBCO thin film. As seen in Figure 2, the horizontal spacing between the vertical lines is about $5\mu m$, such that an ablation strip line width of 0.5mm is formed to separate one junction from another. The laser is then moved vertically down the length of the sample according to the short movement factor (S.M.F) length, horizontally into the sample at a predetermined position along the length and then moved out again. Thereafter, the laser is moved down along the length of the sample according to the long movement factor (L.M.F) length, across the width of 1mm to the other side. The next laser movements include up to a predetermined position along the length of the sample, horizontally into the sample, back out and then back to the top along the length to begin another strip line.

To determine the initial position along the length at which point the laser is moved into the sample, a certain factor is calculated such that division of the length of the sample by this factor will produce a short movement and the factor is called the short movement factor (S.M.F). Division of the length by a second factor will produce a long movement and the factor is called the long movement factor (L.M.F). As can be seen in Figure 2, both these factors determine the separation between the laser spots and hence, the width of the constriction.

The formula for the short movement factor (S.M.F) is:

$$2 * \frac{l}{l - S_w} \hspace{4cm} \textit{(Equation 1)}$$

where $l$ is the length of the square sample (5mm) and $S_w$ is the separation between the laser spots along the length of the sample. The related formula for the long movement factor (L.M.F) is:

$$2 * \frac{l}{l - S_w} \hspace{4cm} \textit{(Equation 2)}$$

To determine the overlapping length of the laser spots and hence, the length of the bridge, a factor is calculated such that division of the width of the sample by this factor provides one with how far to move the laser into the sample. The formula for calculating this length factor (LF) is:

$$\frac{2w}{w - S_L} \hspace{4cm} \textit{(Equation 3)}$$

where $w$ is the width of the sample, 1mm, and $S_L$ is the separation space between the laser spots along the width of the sample. The short movement factor (S.M.F), long movement factor (L.M.F) and the length factor (LF) can all be seen in Figure 2.

Theoretically, the width of a constriction should be given by Equation 4 as given below. However, there are many limitations to this.

$$width\ of\ constrction = S_w - laser\ ablation\ width \hspace{2cm} \textit{(Equation 4)}$$

The overlapping length of the constriction is given by Equation 5.

$$Length\ of\ constriction = S_L - Laser\ ablation\ width \hspace{2cm} \textit{(Equation 5)}$$

The laser feed rate is about 20mm/min or $333 \mu m s^{-1}$. The feed rate is essentially the speed with which the translation stage (26) is moved. The feed rate can be adjusted depending on the requirements, using the interface software for the translation stage (26). Generally, the slower the feed rate, the higher the ablation depth.

Determining the peak laser fluence ablation threshold of the YBCO thin film

The incident peak laser fluence in front of the sample, which is the peak energy density of the laser incident on the sample, is calculated according to Equation 6.

$$F_0 = \frac{2 P_{AVG}}{rep.rate * \pi * w_0^2} \hspace{4cm} \textit{(Equation 6)}$$

In Equation 6, $P_{AVG}$ is the average power effluent from the laser source (12) that eventually reaches the sample after all the optical laser beam shaping components, $rep.\ rate$ is the frequency of the laser pulse or the pulse repetition rate, and $w_0$ is the radius of the measured laser ablation spot used to cut the bridge on the YBCO thin film.

The diameter of the ablation spots, as seen in Figure 4, was measured by scanning using the cantilever tip of an atomic force microscope (AFM). The scanning was done at 90 degrees to the laser spots, such that the transverse line fit on the topography plot yields the diameter of the laser spot, which is about 28.51 $\mu$m ($28.51*10^{-4}cm$) in this case. Equation 6 was then used to calculate the peak laser fluence for each power setting applied to the sample, by substituting the measured ablation beam waist radius $w_0$ in centimeters. Table 1 was extracted by repeating this exercise for several constriction cuts.

Table 1: Finding the peak laser fluence ablation threshold of YBCO thin film ($F_{th,dia}$) using the ablation spot diameter.

| Laser Power (mW) | Peak laser fluence ($F_0$), ($J/cm^2$) | Spot Size ($\mu$m) | Spot Size ($\mu m)^2$, ($D^2$) |
|---|---|---|---|
| 2.7mW | 0.845J/$cm^2$ | 28.51 $\mu$m | 812.82$\mu$m$^2$ |
| 4.22mW | 0.865J/$cm^2$ | 35.25$\mu$m | 1242.56$\mu$m$^2$ |
| 6.88mW | 0.932J/$cm^2$ | 43.36$\mu$m | 1880.09$\mu$m$^2$ |
| 7.9mW | 0.945J/$cm^2$ | 46.13$\mu$m | 2127.98$\mu$m$^2$ |

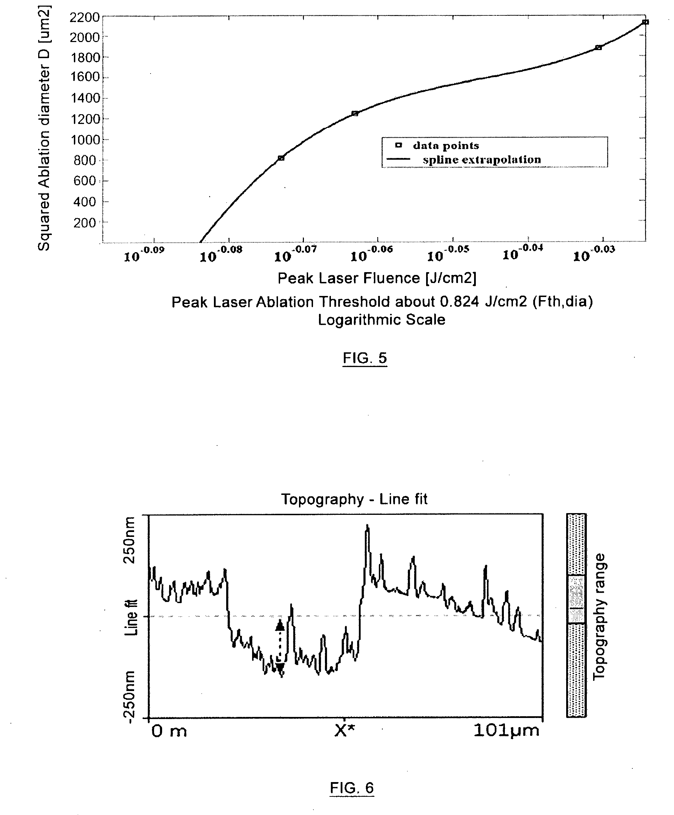

Assuming a spatially Gaussian shape of the beam profile, the peak laser fluence ablation threshold ($F_{th}$) is obtained by plotting the associated square of the laser beam diameter ($D^2$) versus the peak laser fluence ($F_0$) in Figure 5. The smooth curve (or line) represents the spline interpolation technique of curve fitting whilst the blue squares represent the table data points obtained.

Subsequently, using the spline interpolation technique of curve fitting in Matlab, the curve is extrapolated to intersect the X-axis and a peak laser fluence ablation threshold ($Ft_h$) value for YBCO of 0.824J/$cm^2$ is obtained by extrapolation to $D^2 \gg 0^{26}$. The spine interpolation technique is utilized in this case because only a few data points to were available to work with, due to the fact that for each data point, a junction had to be fabricated on the thin film material. With the spine interpolation technique, one is able to extrapolate a few points to the $D^2 \gg O$ on the X-intercept. A semi-logarithmic scale is utilized, such that the squared beam diameter is plotted on the Y-axis on a normal scale, while the peak laser fluence ($F_0$) is plotted on the X-axis on a logarithmic scale, as shown in Figure 5.

Crater topography method to verify the peak laser fluence ablation threshold

To verify the results obtained above for the ablation threshold of YBCO, the crater topography method can also be utilized. During ablation, a crater is formed with a certain depth profile that can be measured using Atomic Force Microscope (AFM) scanning.

Using the transverse, cross-section of the topography line fit scan obtained with the AFM, the depth profile in Figure 6 shows the maximum crater depth to be 146.2nm for incident power of 4.22mW. This method is repeated for a series of AFM scans with varying power to obtain Table 2.

Table 2: Finding the peak laser fluence ablation threshold ($F_{th,dep}$) using the crater depth method.

| Laser Power | Peak Laser fluence | Max crater depth |
|---|---|---|
| 2.7mW | 0.845J/$cm^2$ | 134.5nm |
| 4.22mW | 0.865J/$cm^2$ | 146.2nm |
| 6.88mW | 0.932J/$cm^2$ | 155nm |

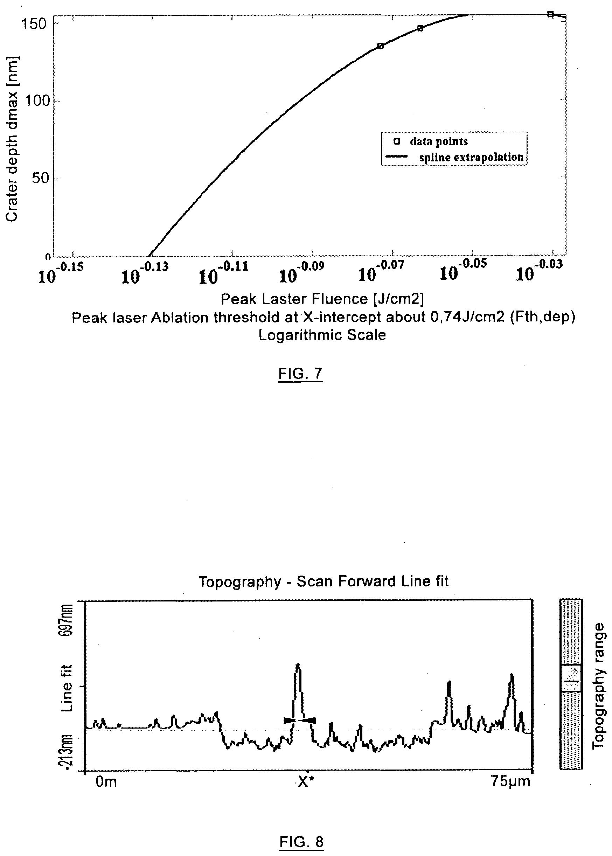

Subsequently the maximum ablation crater depth is plotted versus the peak laser fluence in Figure 7 in which the red line is for the spline fit and the blue line for the table plotted values.

The spline interpolation technique is then used to extrapolate the curve such that it intersects with the x-axis. The peak laser fluence ablation threshold for YBCO is then obtained by extrapolation of $d_{max} \gg 0$. As can be seen in Figure 7, a semi-logarithmic scale is again used.

The value obtained for the peak laser fluence ablation threshold from the crater depths ($F_{th.dep}$) is in close approximation with the value obtained from the ablation diameters ($F_{th,dia}$). Namely (0.74J/cm$^2$, 0.824J/cm$^2$) respectively. There is however a slight difference, which could be attributed to the fact that the number of points used for extrapolation should actually be more to get a precise measurement.

Micron-sized S-shaped constriction fabricated with a spherical convex lens (45mm focal length)

A micron sized S-shaped constriction is fabricated on YBCO superconducting thin film using the above mentioned methodology, with the following: a spherical convex lens of focal length 45mm, a laser power setting of 4.9mW, and a laser beam spot separation ($S_w$) of 18.7$\mu$m - that is the spacing applied between the laser spots in the G-code for the translation stage. The laser ablation spot is 18.05$\mu$m. As can be seen in Figure 8, which is an AFM scan of the sample, the width of the junction achieved at the narrowest point is approximately 1.465$\mu$m. This figure therefore shows the profile distribution of the constriction which is used to measure the width of the constriction precisely.

According to Equation 7 above, the constriction width could theoretically be about 0.7$\mu$m. However, in practice, this is not achieved due to several factors such as the laser room temperature, vibration, air flow and laser feed rate in the room where the experiment is performed.

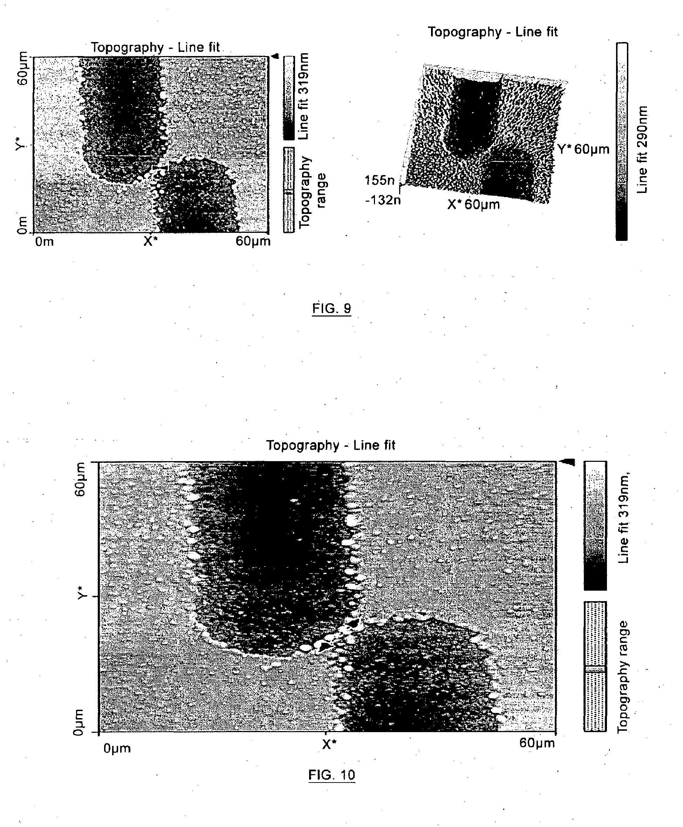

The constriction width can also be determined by drawing a line across the narrowest point on the topography line fit, as can be seen by the two black cursors in Figure 9. In the same way, the constriction length can be determined to be approximately 10.08$\mu$m as seen in Figure 10.

Micron sized S-shaped junction fabricated with a numerical aperture lens of 0.25, with X10 Magnification

The 45mm spherical convex lens was replaced with a numerical aperture (NA) objective lens of 0.25, with X10 magnification in order to reduce the spot size of the laser used for cutting.

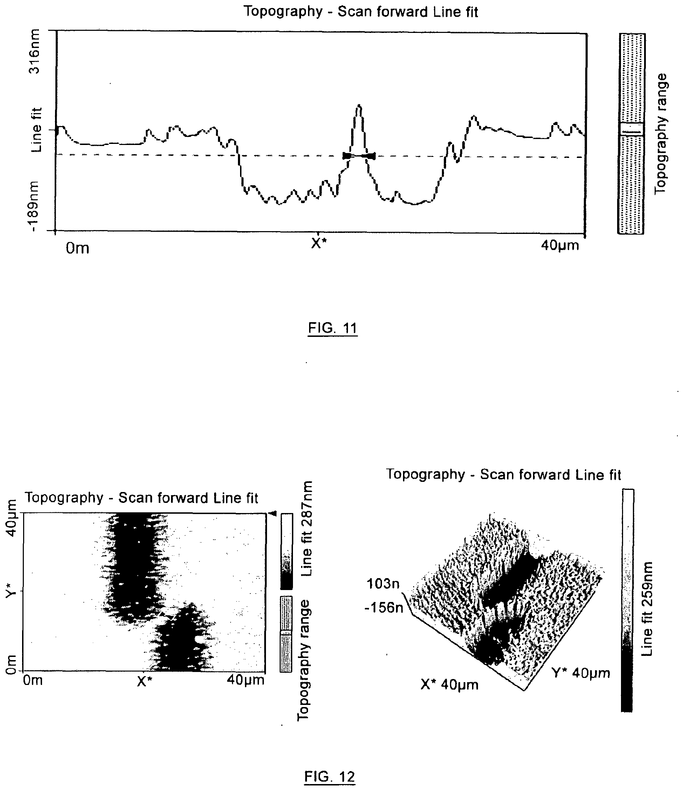

The width of the S-shaped constriction achieved was approximately 1.094$\mu$m, as can be seen in the profile distribution of the constriction made with the AFM in Figure 11. This width is measured at the narrowest point on the constriction, by taking a snap shot whilst the AFM cantelever tip is scanning.

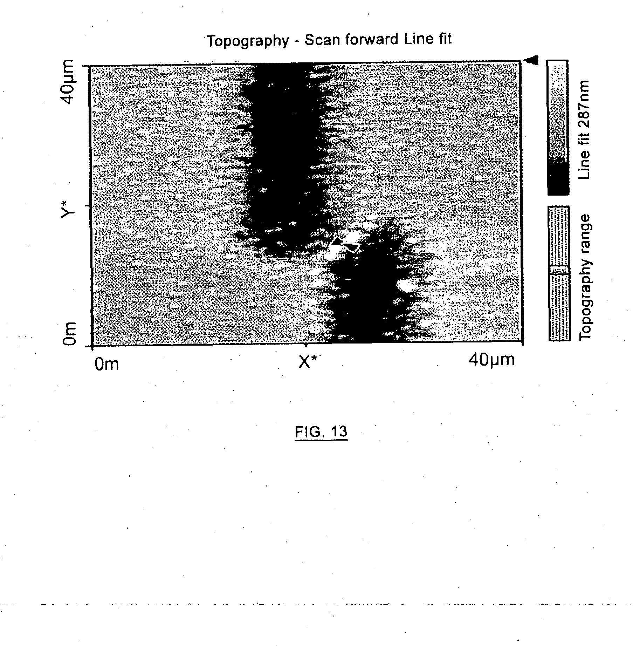

Figure 12 shows the overall constriction scan and the three-dimensional image, whilst Figure 13 indicates the length of the S-shaped constriction by means of the two cursors, measured as 6.322$\mu$m. The laser spot size measured is about 7.344$\mu$m. In using the numerical aperture (NA) lens of 0.25, which focuses the laser further, it was possible to achieve the smaller laser ablation spot size of approximately 7.344$\mu$m. Hence, the separation distance between the spots was reduced to 8.0$\mu$m. Theoretically, as a result of this, the constriction width could be approximately 0.6$\mu$m. However, the junction width actually achieved in the experiment was 1.094$\mu$m.

Due to the fact that the laser ablation spot size is smaller, the laser ablation spots overlap by a lesser extent and therefore, the overlapping length measured also reduces from 10.0$\mu$m to 6.322$\mu$m, as seen in Figure 13, when the NA 0.25 lens is utilized.

Figure 12 shows the constriction width on the topgraphy line fit with the black cursors representing the line width of the constriction as approximtely 1.094$\mu$m.

Sub-micron sized S-shaped junction fabricated with a spherical convex lens (30mm focal length)

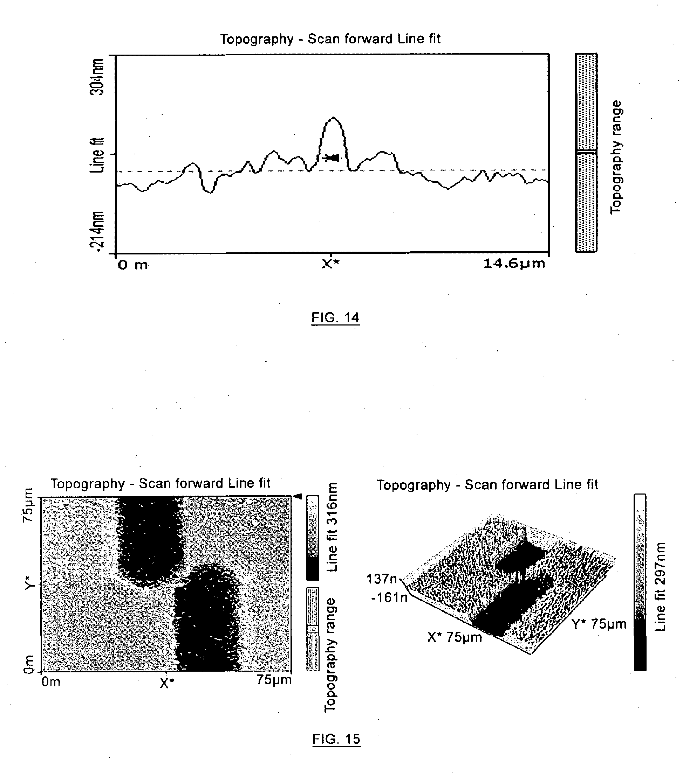

A conventional spherical convex lens of 30mm focal length was also used for cutting the constriction and a sub-micron sized constriction of 858.3nm was achieved. The laser beam ablation spot size increased from the 7.344$\mu$m, achieved with the NA 0.25 objective lens, to 15.8$\mu$m with the 30mm focal length spherical convex lens. However, this spot size is still marginally smaller than that obtained with a 45mm focal length spherical convex lens. Using the 30mm focal length spherical convex lens, with a laser power setting of 2.035mW, a sub-micron sized constriction of width of 858.3nm was achieved, as can be seen in Figure 14. In this figure, a topography line fit is plotted and a snap shot is taken with the AFM at the narrowest point on the constriction. The width is determined by drawing a line across the profile distribution at the narrowest point. The AFM is used to zoom into a scan area of 14.6$\mu$m X 14.6$\mu$m on the sample, just around the constriction, as seen in Figure 14. The separation between the laser spots in the G-code is 16.5$\mu$m and the spot size is 15.8$\mu$m.

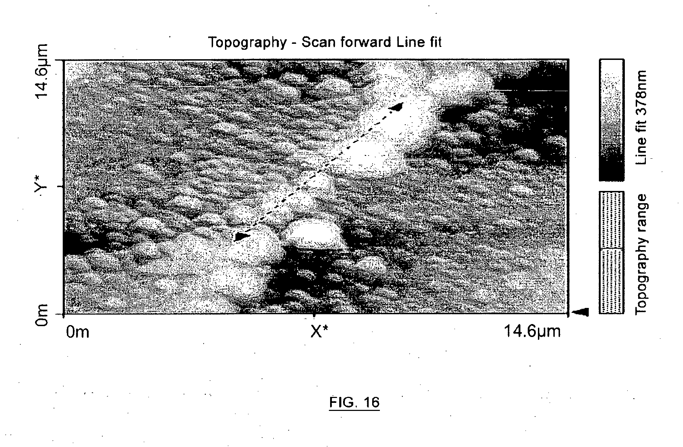

The top view and three-dimensional (3D) view of the constriction is shown in Figure 15. As can be seen in Figure 16, the length of the junction is calculated to be apporoximately 9.657$\mu$m.

Sub-micron sized S-shaped junction fabricated with a spherical convex lens (30mm focal length)

A sub-micron sized junction was fabricated with a constriction width of 576.7nm. The separation between the laser beam spots was set at 16.0$\mu$m in the G-code used to control the translation stage (26), whilst the laser ablation spot size was measured to be 15.8$\mu$m.

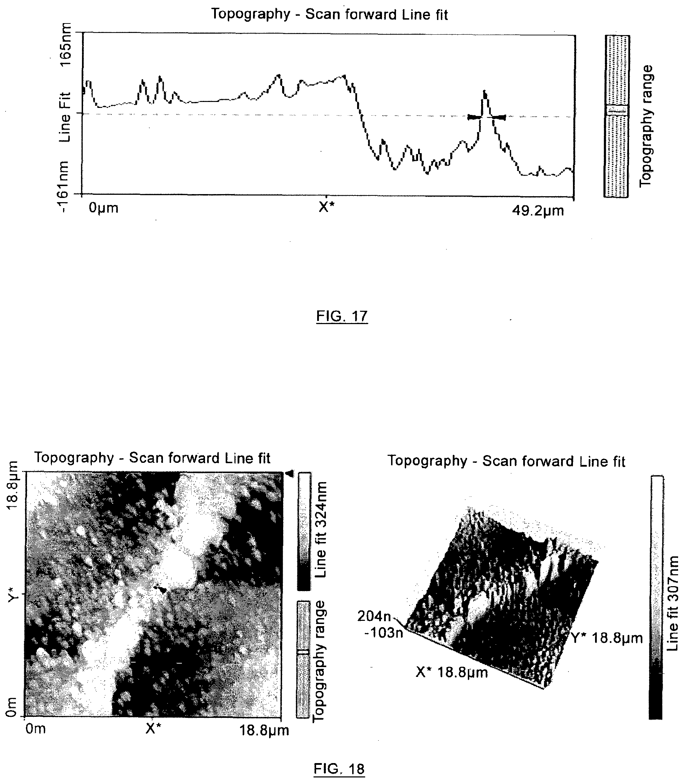

Figure 17 shows the profile of the constriction with a line drawn across the section of the junction that stands above the zero line or altitude. The length of this line gives the width of the junction, approximately 576.7nm.

Figure 18 shows a zoomed-in image of the constriction of Figure 17, with a scan area of 18.8$\mu$m X 18.8$\mu$m. In this figure, the 3D shape of the constriction is clearly visible. At this scale, the constriction is very close to collapsing and this can be observed from the 3D image of it.

The inventor is of the opinion that the invention provides a new method of manufacturing superconducting thin film devices such as nano- and micro-constriction type Josephson junctions, SQUIDS, strip-line resonators and other superconducting devices which are both novel and inventive. The method provides better control over the manufacturing of superconducting thin film devices, which can easily be manufactured by a preprogrammed, femtosecond laser system. Furthermore, the inventor is of the opinion that the invention provides a new superconductor device.

**Claims**

1. A method of manufacturing micro- and nano-constriction type structures on a YBCO thin film for a superconductor device, the method including ablating a predefined pattern onto the thin film by means of a femtosecond laser (12), **characterized in that** the predefined pattern defines an S-shaped constriction defined by two opposed parallel lines, ends of which overlap at least partially to define a constriction between them.

2. The method of claim 1, in which the thin film is a $YBa_2Cu_3O_7$_x thin film.

3. The method of claim 2, in which the thin film is previously deposited on any one of a Magnesium Oxide (MgO) and Lanthanum Aluminate (LAO) substrate.

4. The method of claim 1, in which the laser parameters are in the following ranges:

   the power of the laser to a value of between 1mW and 1W;
   the repitition rate of the laser to a value of between 1kHz and 2kHz;
   the laser beam feed rate to a value of between $16.6\mu m/s$ and $500\mu m/s$;
   the pulse duration of a value of 130fs;
   and the laser beam spot size to a value of between $7.3\mu m$ and $17\mu m$.

5. The method of claim 4, which includes controlling the laser beam separation distance between laser ablation spots in the range of $8\mu m$ to $18\mu m$.

6. The method of claim 4, in which the laser has a wavelength of 795nm, a pulse duration of 130fs and a repetition rate of between 1kHz and 2kHz.

7. The method of claim 1, in which the spacing between the lines is in the range of $5\mu m$ to $10\mu m$.

8. The method of claim 1, in which the pattern to be ablated is defined by a translation stage (26) that controls the movement of the laser (12) to produce the predefined pattern that is to be ablated, the translation stage (26) being controlled by a computer aided manufacturing language.

9. A superconductor device which includes a YBCO thin film onto which a predefined pattern is ablated by means of a femtosecond laser (12), **characterized in that** the predefined pattern defines an S-shaped contriction defined by two opposed parallel lines, ends of which overlap at least partially to define a constriction between them.

10. The superconductor device of claim 8, in which the thin film is a $YBa_2Cu_3O_7$_x thin film.

11. The superconductor device of claim 10, in which the $YBa_2Cu_3O_7$-x thin film is previously deposited on any one of a Magnesium Oxide (MgO) and Lanthanum Aluminate (LAO) substrate.

12. The superconductor device of claim 9, in which the spacing between the lines is in the range of $5\mu m$ to $10\mu m$.

**Patentansprüche**

1. Verfahren zur Herstellung von mikro- und nanokonstriktionsartigen Strukturen auf einer YBCO-Dünnschicht für eine superleitende Vorrichtung, wobei die Methode umfasst
   Abladieren eines vordefiniertes Muster mit Hilfe eines Femtosekundenlasers (12) auf die Dünnschicht, **dadurch gekennzeichnet, dass** das vordefinierte Muster eine S-förmige Verengung bildet, die durch zwei einander gegenüberliegende parallele Linien begrenzt wird, deren Enden sich wenigstens teilweise überlappen, um zwischen sich eine Verengung zu bilden.

2. Verfahren nach Anspruch 1, bei dem die Dünnschicht eine $YBa_2Cu_3O_7$-x-Dünnschicht ist.

3. Verfahren nach Anspruch 2, bei dem die Dünnschicht zuvor auf einem Magnesiumoxid(MgO)-Substrat oder einem Lanthanaluminat(LAO)-Substrat abgeschieden wird.

4. Verfahren nach Anspruch 1, bei dem die Laserparameter in den folgenden Bereichen liegen:

die Leistung des Lasers bei einem Wert zwischen 1 mW und 1 W;
die Wiederholungsfrequenz des Lasers bei einem Wert zwischen 1 kHz und 2 kHz;
die Vorschubgeschwindigkeit des Laserstrahls bei einem Wert zwischen 16,6 $\mu$m/s und 500 $\mu$m/s;
die Impulsdauer bei einem Wert von 130 fs;
und die Spotgröße des Laserstrahls bei einem Wert zwischen 7,3 $\mu$m und 17 $\mu$m.

5. Verfahren nach Anspruch 4, welches ein Kontrollieren des Laserstrahltrennungsabstandes zwischen den Laserablationsspots im Bereich von 8 $\mu$m bis 18 $\mu$m umfasst.

6. Verfahren nach Anspruch 4, bei dem der Laser eine Wellenlänge von 795 nm, eine Impulsdauer von 130 fs und eine Wiederholungsfrequenz zwischen 1 kHz und 2 kHz hat.

7. Verfahren nach Anspruch 1, bei dem der Abstand zwischen den Linien im Bereich von 5 $\mu$m bis 10 $\mu$m liegt.

8. Verfahren nach Anspruch 1, bei dem das zu abladierende Muster durch eine Translationsstufe (26) definiert wird, die die Bewegung des Lasers (12) steuert, um das zu abladierende vordefinierte Muster zu definieren, wobei die Translationsstufe (26) über eine computergestützte Fertigungssprache gesteuert wird.

9. Superleitende Vorrichtung, die eine YBCO-Dünnschicht aufweist, auf die mit Hilfe eines Femtosekundenlasers (12) ein vordefiniertes Muster abladiert wird, **dadurch gekennzeichnet, dass** das vordefinierte Muster eine S-förmige Verendung bildet, die durch zwei einander gegenüberliegende parallele Linien begrenzt wird, deren Enden sich wenigstens teilweise überlappen, um zwischen sich eine Verengung zu bilden.

10. Superleitende Vorrichtung nach Anspruch 8, bei der die Dünnschicht eine $YBa_2Cu_3O_7$-x-Dünnschicht ist.

11. Superleitende Vorrichtung nach Anspruch 10, bei der die $YBa_2Cu_3O_7$_x-Dünnschicht zuvor auf ein Magnesiumoxid(MgO)-Substrat oder ein Lanthanaluminat(LAO)-Substrat abgeschieden wird.

12. Superleitende Vorrichtung nach Anspruch 9, bei der der Abstand zwischen den Linien im Bereich von 5 $\mu$m bis 10 $\mu$m liegt.

## Revendications

1. Procédé de fabrication de structures de type micro- et nano-étranglement sur un film mince d'YBCO pour un dispositif supraconducteur, le procédé comprenant
réaliser une ablation d'un motif prédéfini sur le film mince au moyen d'un laser femtoseconde (12), **caractérisé par le fait que** le motif prédéfini définit un étranglement en forme de S défini par deux lignes parallèles opposées, dont les extrémités se chevauchent au moins partiellement pour définir un étranglement entre celles-ci.

2. Procédé selon la revendication 1, dans lequel le film mince est un film mince d'$YBa_2Cu_3O_7$-x.

3. Procédé selon la revendication 2, dans lequel le film mince est préalablement déposé sur l'un quelconque d'un substrat d'oxyde de magnésium (MgO) et d'aluminate de lanthane (LAO).

4. Procédé selon la revendication 1, dans lequel les paramètres de laser sont dans les plages suivantes :

la puissance du laser à une valeur comprise entre 1 mW et 1 W ;

la fréquence de récurrence du laser à une valeur comprise entre 1 kHz et 2 kHz ;
la vitesse d'avancement de faisceau laser à une valeur comprise entre 16,6 $\mu$m/s et 500 $\mu$m/s ;
la durée d'impulsion d'une valeur de 130 fs ;
et la taille de spot de faisceau laser à une valeur comprise entre 7,3 $\mu$m et 17 $\mu$m.

5. Procédé selon la revendication 4, qui comprend la commande de la distance de séparation de faisceau laser entre des spots d'ablation laser dans la plage de 8 $\mu$m à 18 $\mu$m.

6. Procédé selon la revendication 4, dans lequel le laser présente une longueur d'onde de 795 nm, une durée d'impulsion de 130 fs et une fréquence de récurrence comprise entre 1 kHz et 2 kHz.

7. Procédé selon la revendication 1, dans lequel l'espacement entre les lignes est dans la plage de 5 $\mu$m à 10 $\mu$m.

8. Procédé selon la revendication 1, dans lequel le motif devant subir une ablation est défini par une platine de translation (26) qui commande le déplacement du laser (12) pour produire le motif prédéfini qui doit subir une ablation, la platine de translation (26) étant commandée par un langage de fabrication assistée par ordinateur.

9. Dispositif supraconducteur qui comprend un film mince d'YBCO sur lequel un motif prédéfini subit une ablation au moyen d'un laser femtoseconde (12), **caractérisé par le fait que** le motif prédéfini définit un étranglement en forme de S défini par deux lignes parallèles opposées, dont les extrémités se chevauchent au moins partiellement pour définir un étranglement entre celles-ci.

10. Dispositif supraconducteur selon la revendication 8, dans lequel le film mince est un film mince d'YBa$_2$Cu$_3$O$_7$-x.

11. Dispositif supraconducteur selon la revendication 10, dans lequel le film mince d'YBa$_2$Cu$_3$O$_7$-x est préalablement déposé sur l'un quelconque d'un substrat d'oxyde de magnésium (MgO) et d'aluminate de lanthane (LAO).

12. Dispositif supraconducteur selon la revendication 9, dans lequel l'espacement entre les lignes est dans la plage de 5 $\mu$m à 10 $\mu$m.

FIG.1

FIG. 2

Width of sample (1mm)

YBCO thin film

Length cons

Laser ablation width

Width cons

Length of sample (5mm)

FIG. 3

Topography - Line fit

250nm

Line fit

-250nm

0m          X*          101µm

Topography range

Topography - Line fit

185n

-156n

X*101µm          Y*101µm

Line fit 341nm

FIG. 4

Peak Laser Ablation Threshold about 0.824 J/cm2 (Fth,dia)
Logarithmic Scale

FIG. 5

FIG. 6

Peak laser Ablation threshold at X-intercept about 0,74J/cm2 (Fth,dep)
Logarithmic Scale

FIG. 7

Topography - Scan Forward Line fit

FIG. 8

Topography - Line fit

Topography - Line fit

Line fit 319nm

Topography range

Line fit 290nm

60µm

Y*

0m

0m                    X*              60µm

155n
-132n          X* 60µm

Y* 60µm

FIG. 9

Topography - Line fit

60µm

Y*

0µm

0µm                        X*                        60µm

Line fit 319nm,

Topography range

FIG. 10

Topography - Scan forward Line fit

FIG. 11

FIG. 12

Topography - Scan forward Line fit

FIG. 13

Topography - Scan forward Line fit

FIG. 14

Topography - Scan forward Line fit

Topography - Scan forward Line fit

FIG. 15

Topography - Scan forward Line fit

FIG. 16

FIG. 17

FIG. 18

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 0384521 A
- US 4985117 A

- JP 2008053373 A

**Non-patent literature cited in the description**

- **MURAKAMI et al.** Ultrafast optical magnetic flux generation and the improved THz-imaging. *Physica C,* 2003, vol. 392-396, 401-405
- **MURAKAMI et al.** Optical response of BSCCO thin film in superconducting state. *Physica C,* 2002, vol. 367, 317-321
- **MUTO et al.** New PLAD apparatus and fabrication of epitaxial films and junctions of functional materials: SiC, GaN, ZnO, diamond and GMR layers. *Applied Surface Science,* 2006, vol. 252, 4886-4896

- Fabrication of submicron YBCO Josephson junctions by a sample mosaic navigation assisted laser etching process. **BUETTNER U et al.** SUPERCONDUCTOR SCIENCE AND TECHNOLOGY. IOP PUBLISHING, TECHNO HOUSE, 01 November 2007, vol. 20, S426-S429
- **S. PROYER et al.** Patterning of YBCO Films by Excimer-Laser Ablation. *Applied Physics A,* 01 May 1994, vol. 58 (5), 471-474